# EUROPEAN PATENT APPLICATION

(11) **EP 3 032 595 A1**
(43) Date of publication of application: **15.06.2016**
(21) Application number: 14275252.6
(22) Date of filing: 08.12.2014
(51) Int. Cl.: H01L 33/64, H01L 25/075, H01L 33/62

(54) **A method of manufacturing chip-on-board and surface mount device LED substrate**

(71) Applicant: Millennium Substrates Sdn Bhd, 11960 Penang (MY); Govinda Nair, Baskaran, 46000 Petaling Jaya Selangor (MY)
(72) Inventor: Ramachandran, R. Remakantan, 11950 Penang (MY); Rajangam, Vivegananthan, 14000 Penang (MY)
(74) Representative: Wilson Gunn

(57) **Abstract**

A method of manufacturing Chip-On-Board LED substrate (100) and Surface Mount Device LED substrate (108) is provided, characterized in that, the Chip-On-Board LED substrate (100) and Surface Mount Device LED substrate (108) includes a fine-patterned thick film, the method includes the steps of forming a glass based dielectric layer (103, 111) on a metal plate (101, 109), firing the glass based dielectric layer (103,111), applying a metal based conductor (104, 113) over the dielectric layer (103,111), drying the metal based conductor layer (104,113), firing the glass and metal layers (103, 104, 111,113) producing a thick film and positioning LED die (105) into pockets between circuits for Chip-on-Board application and soldering packaged LED (114) onto the circuit, wherein the method allows for consolidation of thick film and bonding to substrate (100, 108).

## Description

### FIELD OF INVENTION

The present invention relates to a method of manufacturing LED substrate for both Chip on Board and Surface Mount Device.

### BACKGROUND OF INVENTION

With the recent rise of Solid State Lighting (SSL) industry, the major challenge in providing reliability to SSL products is thermal management. As SSL's Light Emitting Diode (LED) produces about 25% light output, the rest (about 75%) produced heat. The heat can reach a critical thermal junction where LED will fail. There is a need for an efficient thermal management at the substrate level.

Substrate or electronic substrate acts as a base for electronics components, Integrated Circuit (IC) or microchips including SSL. Electronic substrate provides the connections to all components and thus making a complete sub-module/module/system.

Therefore, there is a need for a solution to fabricate thermally efficient substrate.

### SUMMARY OF INVENTION

Accordingly there is provided A method of manufacturing Chip-On-Board and Surface Mount Device LED substrate, characterized in that, both the said substrates include a fine-patterned thick film substrate, the method includes the steps of forming a glass based dielectric layer on a metal plate, firing the glass based dielectric layer, applying a metal based conductor over the dielectric layer, drying the metal based conductor layer, firing the glass and metal layers producing a thick film and positioning LED die into pockets between circuits or positioning LED package on anode and cathode pads, wherein the method allows for consolidation of thick film and bonding to substrate.

The present invention consists of several novel features and a combination of parts hereinafter fully described and illustrated in the accompanying description and drawings, it being understood that various changes in the details may be made without departing from the scope of the invention or sacrificing any of the advantages of the present invention.

### BRIEF DESCRIPTION OF THE DRAWINGS

The present invention will be fully understood from the detailed description given herein below and the accompanying drawings which are given by way of illustration only, and thus are not limitative of the present invention, wherein:
FIG. 1 illustrates vertical cross section of the layers of the thick film Chip on Board LED substrate in an embodiment of the present invention.
FIG. 2 illustrates vertical cross section of the layers of the thick film Surface Mount Device Package-On-Board LED substrate in an embodiment of the present invention.

### DETAILED DESCRIPTION OF THE PREFERRED EMBODIMENTS

The present invention relates to a method of manufacturing Chip-On-Board LED substrate. Hereinafter, this specification will describe the present invention according to the preferred embodiments of the present invention. However, it is to be understood that limiting the description to the preferred embodiments of the invention is merely to facilitate discussion of the present invention and it is envisioned that those skilled in the art may devise various modifications and equivalents without departing from the scope of the appended claims.

The following detailed description of the preferred embodiments will now be described in accordance with the attached drawings, either individually or in combination.

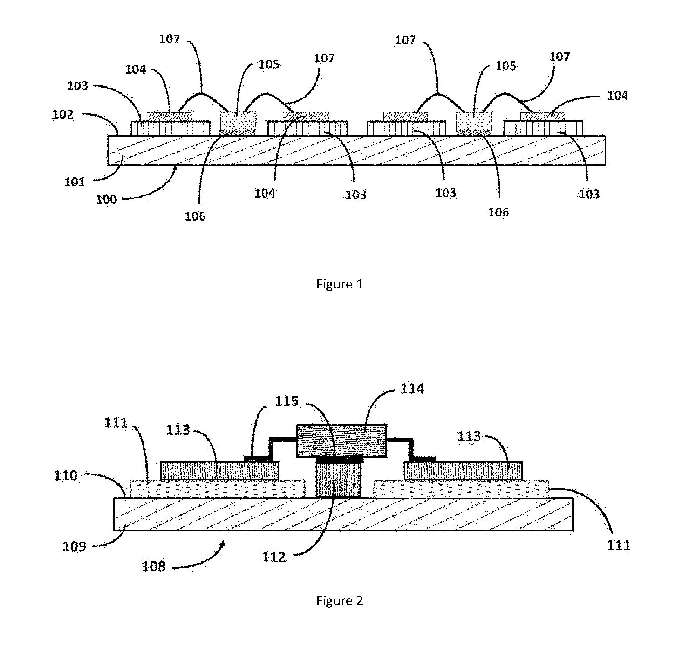

Figure 1 shows a thick film substrate that was produced using a method of manufacturing Chip-On-Board LED substrate (100). The method includes the steps of forming a glass based dielectric layer (103) on a metal plate (101), firing the glass based dielectric layer (103), applying a metal based conductor (104) over the dielectric layer (103), drying the metal based conductor layer (104), firing the glass and metal layers (103, 104)producing a thick film and positioning LED die (105) into pockets between circuits, wherein the method allows for consolidation of thick film and bonding to substrate (100).

As seen in Figure 1, a vertical cross section of the typical thick film Chip-On-Board LED aluminium substrate (100) is shown. An aluminium plate (101) is used as a basic substrate. A flat surface of aluminium (102) must be smoothened by micro polishing. The plate (101) in its preferred embodiment is aluminium grade 3003 series, 5052 series and 6061 series aluminium.

A dielectric layer (103) is made by screen printing a glass based dielectric paste. The printed dielectric paste is dried at a high temperature, approximately 150°C for 15 minutes to remove the solvents. This is followed by a firing process at high temperature of approximately 570°C to burn off any organic binder and consolidate and increase the density of the glass dielectric to minimize the porosity. The purpose of minimizing the porosity is to reduce the possibility of insulation breakdown at high temperature or high voltages. Also, excess porosity may allow the thick film conductor to penetrate through the dielectric layer thereby shorting to the aluminium substrate. The thickness of the printed and fired dielectric is between 50-60 µm.

A screen printed metal based conductor (104) pattern is applied over the dielectric layer (103). The conductor (104) is preferably made of pure Ag with elements such as glass with a melting temperature of below 600°C to enable better bonding with dielectric layer (103). The conductor layer (104) is dried at a high temperature, approximately 150°C for 15 minutes to remove the solvent and the thick film is fires at a high temperature approximately 545°C in order to consolidate the thick film and to provide adequate bonding to the aluminium substrate (100). The thick film once applied can be in the range from about 18-22 µm.

LED die (105) is placed into the pocket between the circuits and glued to the bare aluminium substrate (100) via thermal epoxy (106). Thermal epoxy (106) is then cured at high temperature to ensure LED die (105) is bonded to the aluminium substrate (100).

LED die (105) is connected to the circuitry by wire bonding (107) method. The wire bonding material should be either gold or aluminium wire with diameter between 12.5µm to 200µm *Figure 2* *shows a thick film substrate that was produced using a method of manufacturing Surface Mount Devise Package-On-Board LED substrate (108). The method includes the steps of forming a glass based dielectric layer (111) on a metal plate (109), firing the glass based dielectric layer (111), applying a metal based thermal via (112) direct on the substrate, drying the metal based via (112), firing the metal based via (112), applying metal based conductor layer (113) on dielectric layer (111), drying the metal based conductor layer (113), firing the glass and metal layers (111, 113) producing a thick film and positioning LED package (114) onto the thermal via(112) with joints on metal based conductor (113), wherein the method allows for consolidation of thick film and bonding to substrate (108).*

*As seen in* *Figure 2**, a vertical cross section of the typical thick film Surface Mount Device Package-On-Board LED substrate (108) is shown. An aluminium plate (109) is used as a basic substrate. A flat surface of aluminium (110) must be smoothened by micro polishing. The plate (109) in its preferred embodiment is aluminium grade 3003 series, 5052 series and 6061 series aluminium.*

*A dielectric layer (111) is made by screen printing a glass based dielectric paste. The printed dielectric paste is dried at a high temperature, approximately 150°C for 15 minutes to remove the solvents. This is followed by a firing process at high temperature of approximately 570°C to burn off any organic binder and consolidate and increase the density* of *the glass dielectric to minimize the porosity. The purpose of minimizing the porosity is to reduce the possibility of insulation breakdown at high temperature or high voltages. Also, excess porosity may allow the thick film conductor to penetrate through the dielectric layer thereby shorting to the aluminium substrate. The thickness* of *the printed and fired dielectric is between 50-60 µm.*

*A screen printed metal based thermal via (112) pattern is applied over the aluminium substrate (109). The thermal via (112) is preferably made of pure Ag with elements such* as *glass with a melting temperature of below 600°C to enable better bonding with surface* of *aluminium (110). The thermal via layer (112) is dried at a high temperature, approximately 150°C for 15 minutes to remove the solvent and the thick film is fired at a high temperature approximately 545°C in order to consolidate the thick film and to provide adequate bonding to the aluminium substrate (108). The thick film once applied can be in the range from about 50-60 µm.*

*A screen printed metal based conductor (113) pattern is applied over the dielectric layer (111). The conductor (113) is preferably made of pure Ag with elements such as glass with a melting temperature of below 600°C to enable better bonding with dielectric layer (111). The conductor layer (113) is dried at a high temperature, approximately 150°C for 15 minutes to remove the solvent and the thick film is fired at a high temperature approximately 545°C in order to consolidate the thick film and to provide adequate bonding to the aluminium substrate (108). The thick film once applied can be in the range from about 18-22 µm.*

*LED Package (106) is soldered onto the thermal via (112) and metal based conductor circuits (113). LED package (106) is connected to the circuitry by soldering (115) method. The solder material should be lead free.*

This present invention is able to provide a thick film wire bondable or surface mount technology solderable LED circuitry disposed on an aluminium substrate which is layered with glass based dielectric in order to provide a more uniform surface temperature distribution by more efficient heat dissipation. It is to be appreciated that the method is able to provide better temperature control by a more efficient heat dissipation minimizing the thermal junctions in LED fabrication. This is then a key breakthrough that will enable numerous subsequent advances in LED circuit design that will lead to reduction of temperature junctions in LED fabrication. Lower junction temperature of LED will enable LED's to be designed to be brighter than before using this technology. Greater temperature control and thermal efficiency can be achieved with the use of an aluminium substrate.

It is to be appreciated by those skilled in the art that "Thick film" can mean a metal or glass based paste containing an organic binder and solvent, "Coefficient of thermal expansion (10E-⁶/°C)" (CTE) can mean micro-units of length over units of length per °C Or parts per million per °C; and "W/m-K" is watts per meter Kelvin (units of thermal conductivity). High expansion metal substrates can mean ferrous or non ferrous metal having a CTE of 16x10E⁻⁶/°C or higher.

Thick film LED circuit elements are relatively thick layers of metal circuitry and is typically applied to an electrically isolative dielectric layer on metal substrate that is then used as LED substrate.

Thick film conductor circuitry is typically applied on top of dielectric material that has already been applied on the metal substrate. It is desirable to utilize a glass dielectric in combination with thick film technology because glass based materials provide a very flat and smooth electrically insulated surface layer, glass materials are not porous, and are not moisture absorbing. These characteristics of glass materials allow the thick film to be applied easily while achieving the desired trace pattern and with correct height and width of the trace.

Thick film layers applied to fabricate LED substrate allows a greater flexibility of circuit designs to better achieve uniformity in temperature distribution and to provide precision channelling of surface heat to the bottom of substrate. Also, thick film circuitry can be made to conform to various flat contoured surfaces required for specific LED designs.

## Claims

1. A method of manufacturing Chip-On-Board LED substrate (100) or Surface Mount Device Packaged LED (108), **characterized in that**, the LED substrate includes a fine-patterned thick film,
the method includes the steps of:
i. forming a glass based dielectric layer on a metal plate (103, 111);
ii. firing the glass based dielectric layer (103,111);
iii. applying a metal based conductor over the dielectric layer (104,113);
iv. drying the metal based conductor layer (104,113);
v. firing the glass and metal layers producing a thick film (104,113); and
vi. positioning LED die (105) into pockets between circuits or packaged LED (114) onto the conductive circuit;
wherein the method allows for consolidation of thick film and bonding to substrate (100, 108).

2. The method as claimed in claim 1, wherein printing the thick film layer is performed by silk screen printing.

3. The method as claimed in claim 1, wherein a thin aluminium plate (101,109) is used as a bare substrate with multiple print-dry-fire cycles to form required dielectric and conductor pattern to meet required thickness.

4. The method as claimed in claim 1, wherein the metal based conductor layer (104,113) is silver.

5. The method as claimed in claim 1, wherein the method further includes the steps of fastening the LED die (105) to the substrate (100) by thermal epoxy (106) and bonding the LED die (105) to circuit by wire bonding (107) or the steps of mounting the LED package (114) to the circuit (113) and thermal via (112) by soldering (115).

6. The method as claimed in claim 1, wherein the thin metal plate (101,109) is selected from Aluminium grades of 3003 series, 5052 series or 6001 series.
